Europäisches Patentamt

(19) European Patent Office

Office européen des brevets

(11) EP 0 786 813 A1

(12) **EUROPEAN PATENT APPLICATION**
published in accordance with Art. 158(3) EPC

(43) Date of publication:
30.07.1997 Bulletin 1997/31

(21) Application number: 95934359.1

(22) Date of filing: 29.09.1995

(51) Int. Cl.⁶: $H01L\ 27/12$

(86) International application number:
PCT/RU95/00217

(87) International publication number:
WO 96/10842 (11.04.1996 Gazette 1996/16)

(84) Designated Contracting States:
DE FR GB IT

(30) Priority: 30.09.1994 RU 94037403

(71) Applicant: AKTSIONERNOE OBSCHESTVO
ZAKRYTOGO TIPA "VL"
Moscow, 109240 (RU)

(72) Inventors:
• KRASNIKOV, Gennady Yakovlevich
Zelenograd, 103498 (RU)

• MIKHAILOV, Valery Alexandrovich
Moscow, 119021 (RU)
• MORDKOVICH, Viktor Naumovich
Moscow, 117313 (RU)
• MURASHEV, Viktor Nikolaevich
Moscow, 123459 (RU)
• PRIKHODKO, Pavel Sergeevich
Zelenograd, 103460 (RU)

(74) Representative: Jorio, Paolo et al
STUDIO TORTA S.r.l.,
Via Viotti, 9
10121 Torino (IT)

(54) **FIELD-EFFECT TRANSISTOR OF THE METAL-DIELECTRIC-SEMICONDUCTOR TYPE**

(57) A metal-insulator-semiconductor field-effect transistor comprising an insulation substrate (1) which has at least one source region (2) and at least one drain region (3) disposed on the surface thereof together with corresponding electrodes (4,5) and at least one semiconductor gate region (6) disposed therebetween and on the surface of which a layer of a gate insulator (7) is disposed which has a gate electrode (8) disposed thereon, wherein at least one of said source region (2) or said drain region (3) is a metal conduction region and forms a Schottky barrier.

FIG. 2

EP 0 786 813 A1

## Description

The invention relates to metal-insulator-semiconductor (MIS) field-effect transistors.

Previous Art

A MIS transistor is known in prior art to comprise source and drain regions made in a semiconductor crystal and provided with corresponding electrodes. A gate region is disposed between the source region and the drain region, on the surface of which gate region there is a layer of gate insulator. On the surface of the gate insulator, there is a gate electrode (S.R. Hofstien, F.P. Heiman, "The Silicon Insulated-Gate Field-Effect Transistor", Proc. IEEE, v.51, p.1190, 1963).

Such a transistor design restricts the limiting operating temperature by 100-150°C because of the large surface area of source and drain, and heavy generation currents of "p-n" junctions.

This disadvantage is partially eliminated in a MIS transistor comprising an insulation substrate which had semiconductor source and drain regions disposed thereon [Se.Zee, "Physics of Semiconductor Devices", Book 2, Seciton 8.5.7 "Silicon-on-Insulator Structures", Moscow, Mir Publishers, p.75, 1984).

Besides, the speed of such transistors is limited by the conductance of the source and drain regions and by their capacitances.

A transistor is known in prior art, wherein the source and drain regions form Schottky barriers with a semiconductor crystal (M.P.Lepselter, S.M. Sre, "SB-IGFET: An Insulated-Gate Field-Effect Transistor Using Schottky Barrier Contact as Source and Drain". Proc. IEEE; v.56, p.1088, 1968).

Such a transistor allows to increase speed due to higher conductance of the source and drain regions However, because of the large surface area of source and drain, the limiting operating temperature of this transistor is also not high.

Disclosure of the Invention

The present invention allows to increase substantially the operating temperature, for instance, up to 350-400°C, and to raise the transistor speed by as much as up to 1.5-2 times as compared with known transistors.

This is accomplished owing to the fact that in a transistor according to the invention, comprising an insulation substrate which has at least one source region and at least one drain region disposed on the surface thereof together with corresponding electrodes and at least one semiconductor gate region disposed therebetween and on the surface of which a layer of a gate insulator is disposed which has a gate electrode disposed thereon, at least one of said source region and said drain region is a metal-conduction region.

Along with this, the source and drain regions may comprise metal-conduction regions and may form Schottky barriers.

The semiconductor gate region may consist of several portions, for instance, two or three portions which constitute heavy-doped and light-doped regions of various types of conduction.

Besides, the source and drain regions may be made of a metal-conduction layer and a semiconductor layer adjacent to the insulation substrate and filled up completely with a space-charge region formed by the Schottky barriers of the source and drain regions.

Also, the transistor may have two source regions, two semiconductor gate regions of the first and second types of conduction, and a metal-conduction drain region forming Schottky barriers with the two gate regions.

Along with this, one of the source regions or both of them may comprise metal-conduction regions forming Schottky barriers.

An additional heavy-doped semiconductor region of the first or second type of conduction with a corresponding electrode may be arrnaged on the surface of the insulation substrate so that it is adjacent to the gate region of the first type of conduction.

There can be two such additional regions of the first and second types of conduction and, if such is the case, they are adjacent to the gate region on the opposite sides thereof.

As a material for the gate region, use can be made of a semiconductor silicide, for instance, iron silicide.

Brief Description of the Drawings

The present invention will now be described with reference to the accompanying drawings illustrating embodiments thereof, in which:

Fig.1 is a top view of a transistor according to the invention;
Fig.2 is a lateral sectional view of the transistor shown in Fig.1, along line II-II;
Fig.3 is a lateral sectional view of the transistor shown in Fig.1, wherein the gate region consists of two portions;
Fig.4 is a lateral sectional view of the transistor shown in Fig.1, wherein the gate region consists of three portions;
Fig.5 is a lateral sectional view of a transistor in which the source and drain regions consist of several layers;
Fig.6 is a top view of a transistor accoridng to the invention, which has an additional semiconductor region;
Fig.7 is a top view of a transistor according to the invention which has two additional semiconductor regions;
Fig.8 is a top view of a transistor accoridng to the invention, with two source regions and two gate regions; and
Fig.9 is a lateral sectional view of the transistor shown in Fig.8, along line IX-IX.

## Embodiment of the Invention

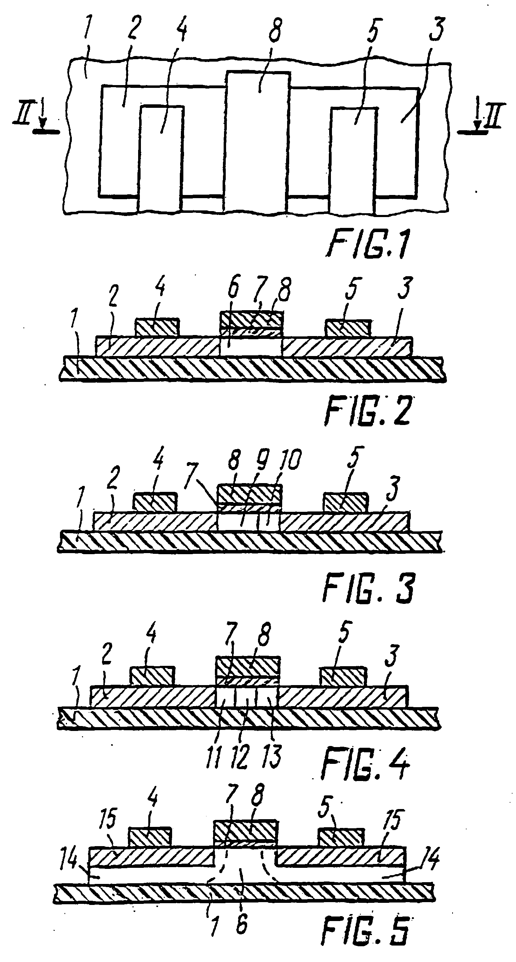

Figs. 1 and 2 illustrate a transistor having an insulation substrate 1 which has a source region 2 and drain region 3 disposed thereon. The source region is provided with a source electrode 4, and the drain region, with a drain electrode 5. A semiconductor gate region 6 is disposed between the source region and the drain region, to the surface of which gate region a layer of gate insulator 7 is applied, the layer having a gate electrode 8.

In Figs. 3 and 4 the semiconductor gate region of the transistor consists of two portions 9 and 10, and three portions 11, 12 and 13, respectively.

In Fig.5 the source and drain regions of the transistor have two layers 14 and 15.

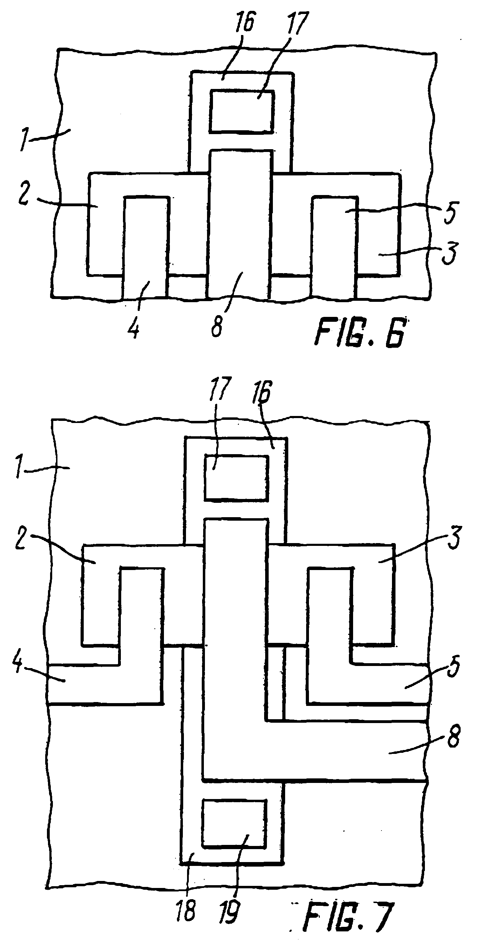

In Fig.6, a transistor is provided with an additional semiconductor region 16 with its own electrode 17, which additional region is arranged on the insulation substrate adjacent to the semiconductor gate region. There can be two such additional regions adjacent to the semiconductor gate region on the opposite sides thereof, as shown in Fig.7. The second additional semiconductor region 18 is provided with its own electrode 19.

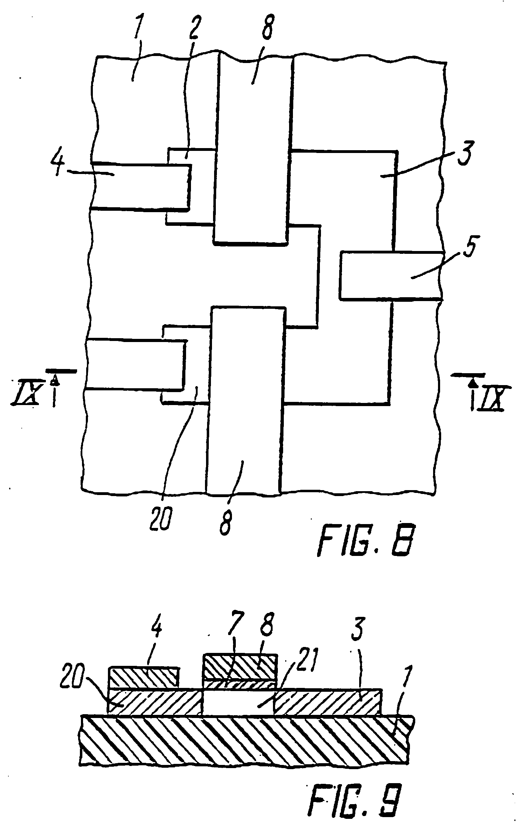

According to Figs.8 and 9, a transistor has a second source region 20 and a second semiconductor gate region 21.

The principle of action of a MIS field-effect transistor is based on the transfer of charge carriers from the source region 2 to the drain region 3 through the semiconductor gate region 6 and on controlling over this process by voltage applied to the gate electrode 8 so as to vary the conduction of the semiconductor gate region.

When voltage is applied between the source and drain, the source region emits charge carriers into the semiconductor gate region, which charge carriers move under the influence of an electric field toward the drain region. Depending upon the sign and value of the potential between the gate electrode 8 and the source electrode 4, the electrical conduction of the gate region can vary both in magnitude and in the type of conduction. This allows to control the value of current through the transistor down to almost complete cutoff thereof.

At zero potential of the gate, the conduction of the near-the-surface layer of the semiconductor gate region depends upon the value and sign of the charge in the gate insulator 7. In accordance with this, the transistor can be normally on (the source-drain current flows at zero potential of the gate and can be cut off at a certain value of the potential of the gate) or normally off (for the current to flow from the source to the drain, it is necessary to ensure a potential at the gate). With this, the electrical properties of the source (drain) - semiconductor gate region system (i.e., they form Schottky barriers, a "p-n" junction or an ohmic contact) influence on output and transfer characteristics of transistors and their modes of operation but do not change the principle of functioning of the devices.

The transistor accoridng to Figs. 1 and 2, in which at least one of the drain region or the source region is a metal-conduction region, changes over to an on or off state when the voltage $V_3$ at the gate reaches the value of the threshold voltage $V_n$. In case if both of the source and drain regions are metal-conduction regions, form an ohmic contact, and the charge in the gate insulator 7 approaches zero, then the transistor is in an off state. In case if these metal-conduction regions form Schottky barriers, then the transistor changes over to an on state. The metallic conduction of at least one of the drain region or the source region improves heat resistance up to, e.g., 350-400°C and the speed by as much as up to 1.5-2 times owing to an increase in the transistor conductance and to a reduction in the thermogeneration areas.

In the transistor according to Fig.3, the portions 9 and 10 of the semiconductor gate region are regions of different doping level, one of which is lightly doped, and the other, heavily doped.

When voltage $V_3 < V_n$ is applied to the gate, and voltage $V_c$ is applied to the drain relative to the source, at the place where the light-doped portion of the semiconductor gate region is in contact with the metal-conduction region, a Schottky barrier is formed which has its associated width of a space-charge region (SCR) and practically does not conduct current at reverse bias. With an increase in voltage at the gate so that $V_3 < V_n$, the concentration of charge carriers at the boundary of the above-mentioned regions increases and the width of SCR decreases. The Schottky barrier changes over to a tunneling transparent barrier, and the transistor begins to conduct current.

In case of forward bias of the Schottky barrier by voltage $V_c$, a change in the transistor conductance takes place due to modulating the volt-ampere characteristic of the Schottky barrier by the gate voltage $V_3$. Use made of a controllable transition of the Schottky barrier into a tunneling transparent barrier in a field-effect transistor allows to improve both speed and slope, since the channel effective length in such a transistor corresponds to the width of SCR.

The portions 9 and 10 of the semiconductor gate region have also different types of conduction. Thus, for instance, the portion 9 is a light-doped region of the second type of conduction, and the portion 10 is a heavy-doped region of the first type of conduction. In this case, when voltage $V_3$ is applied that approaches to zero, and the reverse voltage $V_c$ is applied to the drain, the transistor is off. As soon as $V_3 = V_{n1}$ is reached, the transistor goes on and operates as a conventional enhancement-type MIS transistor (for instance, "p"-channel). However, as the sign of $V_c$ at the drain-source changes and $V_3 = V_{n2}$ is reached that is opposite to $V_{n1}$ in sign, the transistor begins to operate similarly to the transistor as described above, i.e., like an "n"-channel transistor.

In the transistor shown in Fig. 4, the portions 11 and 13 of the semiconductor gate region are regions of the first type of conduction, and the portion 12 is a region of the second type of conduction. Such a transistor operates as an "n"-channel or "p"-channel transistor, depending upon the level of doping the regions, for instance, the portion 13 is a heavy-doped region, and the portions 11 and 12 are light-doped regions. The regions of the first type of conduction being present allow to improve the stability of the transistor threshold voltage.

In a transistor accoridng to Fig. 5, the source and drain regions are made to consist of the semiconductor layer 14 which is disposed on the insulation substrate and completely filled up with SCR formed by the Schottky barriers of the source and drain regions, as well as the metal-conduction layer 15.

A transistor shown in Fig.6 is provided with one additional heavy-doped semiconductor region 16 having the first or second type of conduction or else, as shown in Fig. 7, by two additional regions 16 and 18 off the first and second types of conduction.

Figs. 8 and 9 illustrate a transistor in which the two source regions 2 and 20, the two semiconductor gate regions 6 ans 21 of the first and second types of conduction and the metal-conduction drain region 3 form Schottky barriers with both of the gate regions. In this case, one or both of the source regions comprise metal-conduction regions forming Schottky barriers.

Industrial Applicability

A transistor according to the present invention can be used in various semiconductor devices where increased operating temperature and high speed are required.

**Claims**

1. A metal-insulator-semiconductor field-effect transistor comprising an insulation substrate (1) which has at least one source region (2) and at least one drain region (3) disposed on the surface thereof together with corresponding electrodes (4,5) and at least one semiconductor gate region (6) disposed therebetween and on the surface of which a layer of a gate insulator (7) is disposed which has a gate electrode (8) disposed thereon, **characterized in that** at least one of said source region (2) or said drain region (3) is a metal-conduction region,

2. The transistor according to Claim 1, **characterized** in that said source (2) and drain (3) regions comprise metal-conduction regions.

3. The transistor according to Claims 1 and 2, **characterized** in that said metal-conduction regions form Schottky barriers.

4. The transistor according to Claim 3, **characterized** in that said semiconductor gate region (6) consists of two portions (9, 10), one of which is a heavy-doped region, and the other is a light-doped region.

5. The transistor according to Claim 4, **characterized** in that said portion (10) adjacent to said drain region (3) is a heavy-doped region of the first type of conduction, and said portion (9) adjacent to said source region (2) is a light-doped region of the second type of conduction.

6. The transistor accoridng to Claim 4, **characterized** in that said portion (9) adjacent to said source region (2) is a heavy-doped region of the first type of conduction, and said portion (10) adjacent to said drain region (3) is a light-doped region of the second type of conduction.

7. The transistor according to Claim 3, **characterized** in that said semiconductor gate region (6) consists of three portions (11, 12, 13), wherein said portion (11) adjacent to said source region (2) and said portion (13) adjacent to said drain region (3) are regions of the first type of conduction, and said portion (12) disposed therebetween is a region of the second type of conduction.

8. The transistor according to Claim 7, **characterized** in that said portion (13) adjacent to said drain region (3) is a heavy-doped region, and said other portions (11, 12) are light-doped regions.

9. The transistor according to Claims 3 to 8, **characterized** in that said source (2) and drain (3) regions are made of a metal-conduction layer (15) and a semiconductor layer (14) adjacent to the insulation substrate (1) and filled up completely with a space-charge region formed by the Schottky barriers of said source (2) and drain (3) regions.

10. The transistor according to Claims 3 to 9, **characterized** in that an additional heavy-doped semiconductor region (16) of the first type of conduction is arranged on the surface of the insulating substrate (1), said additional region having an electrode (17) disposed thereon, and said additional region being adjacent to said semiconductor gate region (6) of the first type of conduction.

11. The transistor according to Claim 10, **characterized** in that said additional heavy-doped semiconductor region (16) comprises a region of the second type of conduction.

12. The transistor according to Claim 3 to 11, **characterized** in that two additional heavy-doped semiconductor regions (16, 18) of the first and second type of conduction are arranged on the insulation substrate (1), said additional regions having electrodes (16, 19) disposed thereon, and said additional regions being adjacent to said semiconductor gate region (6) on the opposite sides thereof.

13. The transistor according to Claims 3 to 12, **characterized** in that said transistor comprises two source regions (2 , 20), two semiconductor gate regions (6, 21) of the first and second types of conduction, and a metal-conduction drain region (3) forming Schottky barriers with said two semiconductor gate regions (6, 21).

14. The transistor according to Claim 13, **characterized** in that one of said source regions comprises a metal-conduction region forming a Schottky barrier.

15. The transistor according to Claim 13, **characterized** in that both of said source regions (2, 20) comprise metal-conduction regions forming Schottky barriers.

16. The transistor according to Claims 1 to 15, **characterized** in that said semiconductor gate region (6) is made of a semiconductor silicide.

FIG.1

FIG.2

FIG. 3

FIG. 4

FIG. 5

FIG. 6

FIG. 7

FIG. 8

FIG. 9

## INTERNATIONAL SEARCH REPORT

| International application No. |
| --- |
| PCT/RU 95/ 00217 |

**A. CLASSIFICATION OF SUBJECT MATTER**

IPC6 : H01L 27/12

According to International Patent Classification (IPC) or to both national classification and IPC

**B. FIELDS SEARCHED**

Minimum documentation searched (classification system followed by classification symbols)

IPC6 : H01H 27/00,27/02,27/12,29/68,29/76,29/78,29/772 US C1 3177235R

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y<br>A | Ju. POZHELA "FIZIKA BYSTRODEISTVUJUSCHIKH TRANZISTOROV",<br>1989, "MOKSLAS" (VILNJUS), pages 88-89 | 1-3<br>4-16 |
| Y<br>A | US, A, 4554569 (PER-ARNE TOVE ET AL),<br>19 November 1985 (19.11.85) | 1-3<br>4-16 |
| A | FR, A1, 2452788 (TOKYO SHIBAURA DENKI KK)<br>24 October 1980 (24.10.80) | 1-16 |
| A | US, A, 4106045 (THE PRESIDENT OF THE AGE NCY OF<br>INDUSTRIAL SCIENCE END TECHNOLOGY)<br>08 August 1978 (08.08.78) | 1,5,6,7 |
| A | US, A, 3609477 (INTERNATIONAL BUSINESS MACHINES<br>CORPORATION), 28 September 1971 (28.09.71) | 1-16 |

X Further documents are listed in the continuation of Box C.     ☐ See patent family annex.

* Special categories of cited documents:

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance: the claimed invention cannot be considered novel or cannot be considered to involve an inventive step when the document is taken alone

"Y" document of particular relevance: the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
| --- | --- |
| 01 February 1996 (01.02.96) | 14 February 1996 (14.02.96) |

| Name and mailing address of the ISA/ RU | Authorized officer |
| --- | --- |
| | |
| Facsimile No. | Telephone No. |

Form PCT/ISA/210 (second sheet) (July 1992)

9

**INTERNATIONAL SEARCH REPORT**

International application No.

PCT/RU 95/000217

| C (Continuation). DOCUMENTS CONSIDERED TO BE RELEVANT | | |
|---|---|---|
| Category* | Citation of document, with indication, where appropriate, of the relevant passages | Relevant to claim No. |
| A | DE, A1, 3313163 (TOKYO SHIBAURA DENKI K.K.), 20 October 1983 (20.10.83) | 1-16 |
| A | FR, A1, 2268361 (RCA CORPORATION), 14 November 1975 (14.11.75) | 1-16 |

Form PCT/ISA/210 (continuation of second sheet) (July 1992)